# EUROPÄISCHE PATENTSCHRIFT

(11) **EP 2 400 664 B1**
(45) Veröffentlichungstag und Bekanntmachung des Hinweises auf die Patenterteilung: **06.11.2013**
(21) Anmeldenummer: 11162554.7
(22) Anmeldetag: 15.04.2011
(51) Int. Cl.: H03K 17/96

(54) **Verfahren zur Herstellung eines optoelektronischen Sensors mit einem Bedienelement**
Method for producing an optoelectronic sensor with an operating element
Procédé de fabrication d'un capteur optoélectronique doté d'un élément de commande

(30) Priorität: 24.06.2010 DE 102010024900
(43) Veröffentlichungstag der Anmeldung: 28.12.2011
(73) Patentinhaber: SICK AG, 79183 Waldkirch (DE)
(72) Erfinder: Döbele, Christian, 79341 Kenzingen (DE); Yltchev, Georgy, 79194, Gundelfingen (DE)
(74) Vertreter: Ludewigt, Christoph

(56) Entgegenhaltungen:
- EP-A1- 0 777 327
- EP-A1- 2 034 499
- DE-C2- 3 214 446
- US-A- 4 536 625
- US-A1- 2002 027 062

## Beschreibung

Die Erfindung betrifft ein Verfahren zur Herstellung eines optoelektronischen Sensors mit einem Bedienelement.

Die EP 0 777 327 A1 betrifft einen Drucktastenschalter für Haushaltsgeräte, wobei der Drucktastenschalter als optischer Schalter mit Lichtsender und Lichtempfänger ausgebildet ist. Dabei wird durch Verschiebung eines Tastenschiebers ein Strahlengang zwischen einer Leuchtdiode und einem Photodetektor unterbrochen.

Die US 4, 536,625 betrifft eine Tastatur aus elastischen Tasten. Die Tasten weisen an einer Unterseite eine leitfähige Beschichtung auf. Durch das Betätigen der Taste wird die leitfähige Beschichtung gegen ein Kontaktpaar gedrückt, so dass eine leitfähige Verbindung hergestellt ist.

Die DE 32 14 446 C2 betrifft einen Befehlsgeber, insbesondere für Aufzugssteuerschaltungen, mit einem Drucktaster, der aus einem Tastkörper und einem damit verbundenen Übertragungsglied besteht, mit einer mit Hilfe des Übertragungsgliedes Drucktasters betätigbaren Lichtschranke zur Erzeugung mindestens eines Impulses in einer angeschlossenen elektrischen Steuerschaltung, ferner mit einem den Tastkörper führenden und in einer Aufnahmeplatte einbaubaren Gehäuse sowie mit einer Lampe als bei Erzeugung des Impulses ansprechenden Rückmeldeorgan.

Die US 2002/0027062 A1 offenbart ein Gerät mit einem Gehäuse und angeordneten Drucktasten. Eine Drucktaste betätigt einen Hebel über welchen ein elektrischer Kontakt geschlossen wird.

Die EP 2 034 499 A1 offenbart eine Taster der auf einen Hebel wirkt, wobei der Hebel auf ein Kontaktelement wirkt.

In Geräten und Baugruppen kann es durch einzelne Unterbaugruppen und Einzelteile durch Toleranzverkettungen der Einzelkomponenten zu starken Gesamttoleranzschwankungen an funktionsbedingten Schnittstellen kommen. Bei einem typischen Bedienelement mit einem elektrischen Tastelement, das in der Regel auf einer Elektronik-Karte angeordnet ist, wirken Toleranzen des Schaltmechanismus des elektrischen Tastelements, also der Lage des Schaltpunktes, der angibt, wie weit das elektrische Tastelement gedrückt werden muss, ehe das Umschalten erfolgt, eine Bestücktoleranz des Schalters auf der Elektronik-Karte, eine Toleranz der Aufnahme der Elektronikkarte in das Gehäuse und eine Toleranz des Gehäuses zu einer außenliegenden Bedienfläche zusammen. Ist ein mechanisches Übertragungselement vorgesehen, wie es insbesondere im Fall von als Metallmembranen auf einem Gehäuse eines optoelektronischen Sensors ausgeführten Bedienelementen oft verwendet wird, um das Gehäuse zu durchsetzen und so die Betätigung eines im Gehäuseinneren liegenden elektrischen Tastelements zu ermöglichen, kommen auch dessen Toleranzen noch hinzu.

Um einen Schaltvorgang auszulösen, muss das elektrische Tastelement um einen Mindesthub betätigt werden, während zugleich für die Bedienfläche nur ein begrenzter Hub verfügbar ist. Durch Kombination der Einzeltoleranzen zu einer Gesamttoleranz kann es dabei zu drei unterschiedlichen Problemen kommen:
1) Wenn die Toleranzen so zusammenwirken, dass ein maximaler Abstand zwischen der Bedienfläche und dem Schaltpunkt des elektrischen Tastelements vorliegt, kann es vorkommen, dass der maximal verfügbare Hub nicht ausreicht, um zu einem Schalten des elektrischen Tastelements zu führen. Die Betätigung der Bedienfläche bleibt folgenlos, das Bedienelement versagt.
2) Wenn die Toleranzen so zusammenwirken, dass ein minimaler Abstand zwischen der Bedienfläche und dem Schaltpunkt des elektrischen Tastelements vorliegt, kann beim Fügen der Baugruppe durch Vorspannung zwischen Bedienfläche und elektrischem Tastelement eine Dauerbetätigung ausgelöst werden.
3) Wenn die Toleranzen so zusammenwirken, dass ein Abstand zwischen minimalem Abstand und Sollabstand zwischen Bedienfläche und dem Schaltpunkt des elektrischen Tastelements vorliegt, ist der verfügbare Hub zu groß. Dann kann es vorkommen, dass der Benutzer mit hohem Krafteinsatz das Bedienelement betätigt und dadurch nicht nur das Schalten des elektrischen Tastelements bewirkt, sondern dieses durch ungedämpftes Einleiten der aufgewendeten Bedienkraft beschädigt. Lagerungen und Lötverbindungen eines elektrischen Tastelements sind üblicherweise für deutlich geringere Kräfte ausgelegt, als maximal über Bedienfläche und ein mechanisches Übertragungselement übertragbar sind.

Aufgabe der Erfindung ist die Bereitstellung eines Verfahrens zur Herstellung eines optoelektronischen Sensors mit einem Bedienelement ohne diese Nachteile.

Die Aufgabe wird erfindungsgemäß gelöst durch ein Verfahren mit den Merkmalen des Patentanspruchs 1. Vorteilhafte Ausgestaltungen und Weiterbildungen der Erfindung sind in den Unteransprüchen angegeben.

Das erfindungsgemäße Verfahren zur Herstellung eines optoelektronischen Sensors mit einem Bedienelement, das eine Bedienfläche, ein elektrisches Tastelement und ein mechanisches, als Folge einer Betätigung der Bedienfläche bewegliches Übertragungselement zur Betätigung des elektrischen Tastelements aufweist, weist zumindest die folgenden Schritte auf: Anordnen des elektrischen Tastelements in oder an dem optoelektronischen Sensor, Einlegen des mechanischen Übertragungselements in den optoelektronischen Sensor, so dass durch Bewegung des mechanischen Übertragungselements ein Schalten des elektrischen Tastelements auslösbar ist, Überführen des mechanischen Übertragungselements in eine Position, in der es ein Schalten des elektrischen Tastelements auslöst und Festhalten des mechanischen Übertragungselements in dieser Position, und Anpassen der Länge des mechanischen Übertragungselements in Arbeitsrichtung zur Toleranzeliminierung. Unter der Arbeitsrichtung wird dabei die Richtung verstanden, in die in das mechanische Übertragungselement bei Betätigung der Bedienfläche des Bedienelements Kraft eingeleitet wird. Insbesondere können die Schritte in dieser Abfolge durchgeführt werden. Die Längenanpassung sollte vorteilhafterweise vor dem endgültigen Anordnen der Bedienfläche an dem optoelektronischen Sensor erfolgen.

Dadurch, dass das mechanische Übertragungselement erfindungsgemäß in eine Position überführt wird, in der es ein Schalten des elektrischen Tastelementes auslöst und dann die Länge des mechanischen Übertragungselements individuell angepasst wird, werden Bauteiltoleranzen ausgeglichen, so dass bei den auf diese Weise hergestellten optoelektronischen Sensoren mit Bedienelement die oben genannten Probleme nicht mehr auftreten können. Der Ausschuss an Geräten bei der Herstellung und das Risiko einer Beschädigung des Bedienelements bei seiner Betätigung wird sicher eliminiert, was zu spürbarer Kostenreduktion führt.

Das Einlegen des mechanischen Übertragungselements umfasst vorteilhafterweise das Anschlagen in eine Aufnahme referenzierend zu einer beispielsweise im oder am Gehäuse des optoelektronischen Sensors vorgesehenen Referenzfläche.

Das Überführen des mechanischen Übertragungselements in eine Position, in der es ein Schalten des elektrischen Tastelementes auslöst, kann beispielsweise mittels eines gefederten Elementes geschehen, das auf einen Vorsprung oder Abschnitt des mechanischen Übertragungselements einwirkt, der nicht von der nachfolgenden Anpassung der Länge in Arbeitsrichtung betroffen wird.

In einer ersten bevorzugten Ausführungsform erfolgt das Anpassen der Länge des mechanischen Übertragungselements durch Abschmelzen. Dazu kann beispielsweise ein heißer Stempel auf das mechanische Übertragungselement, der so zu einer Gehäusekante referenziert ist, dass auch bei dem kleinsten innerhalb der Toleranzen für die Bedienfläche auftretenden Hub der Schaltprozess ausgelöst wird, gefahren werden. Das abgeschmolzene Material setzt sich als umlaufender Wulst am mechanischen Übertragungselement ab.

Zweckmäßigerweise wird als Material für das mechanische Übertragungselement ein Material verwendet, das sich nach dem Abschmelzvorgang gut vom Heißstempel trennen lässt. Bevorzugt ist die Verwendung von POM-Kunststoff wegen der guten Gleiteigenschaften, hohen Elastizität und guten Schmelzeigenschaften dieses Materials. Bei Verwendung dieses Materials kann ein auf 300° C bis 400° C, insbesondere 380° C daueraufgeheizter Stahlstempel benutzt werden, abhängig von der Geometrie und Material des Übertragungselements, wenn die beim Verbrennen des POM-Materials entstehenden kanzerogenen Dämpfe abgesaugt werden. Alternativ kann mit einem sogenannten "Heat-Staker" das Material unterhalb der Verbrennungsgrenze abgeschmolzen werden. Die Ablösung vom abgeschmolzenen mechanischen Übertragungselement erfolgt durch eine termporäre Kühlung des Heißstempels durch einen Luftstrom.

In einer zweiten bevorzugten Ausführungsform erfolgt das Anpassen der Länge des mechanischen Übertragungselements durch Abfräsen. Die Vorteile beim Abfräsen liegen darin, dass eine sehr gute Maßhaltigkeit und ein sehr hohes Toleranzausgleichsvermögen gegeben sind, allerdings kann ein gewisses Risiko, dass es zum Eindringen von Stäuben oder Spänen in den optoelektronischen Sensor kommt, bestehen. Die zu erreichende Frästiefe kann fest auf einen Bezugsanschlag, z. B. eine Bezugskante, am oder im Gehäuse des optoelektronischen Sensors referenziert werden.

In einer dritten bevorzugten Ausführungsform erfolgt das Anpassen der Länge des mechanischen Übertragungselements durch Abkneifen. Auch hier kann die zu erreichende Tiefe über einen Bezugsanschlag, z. B. eine Bezugskante, am oder im Gehäuse des optoelektronischen Sensors referenziert werden. Diese Vorgehensweise zeichnet sich durch einen besonders einfachen Aufbau und ein hohes Toleranzausgleichsvermögen aus, allerdings ist die Prozesssicherheit weniger gut als bei alternativen Vorgehensweisen und die Form der Fläche des mechanischen Übertragungselements, die mit der Bedienfläche wechselwirkt, ist nicht optimal.

In einer vierten bevorzugten Ausführungsform erfolgt das Anpassen der Länge des mechanischen Übertragungselements durch Auftrag eines Klebstoffs. Im Gegensatz zu den vorstehenden Ausgestaltungen wird dabei ein mechanisches Übertragungselement verwendet, das verlängert werden muss, um die Solllänge zu erreichen. Zur Verlängerung des mechanischen Übertragungselements wird auf die der Bedienfläche zugewandte Oberfläche des mechanischen Übertragungselements ein zäher Klebstoff aufgetragen, so dass sich ein Klebstofftropfen bildet, der über die Sollhöhe hinausragt. Anschließend wird die Höhe des Klebstofftropfens dadurch angepasst, dass ein am Klebstoff nicht haftendes Distanzstück, z. B. aus Teflon, mit einem Bezugsanschlag am oder im Gehäuse in Anschlag gebracht wird. Diese Lösung erreicht gute Maßhaltigkeit, das Toleranzausgleichsvermögen ist aber gering. Die Geschwindigkeit bei dieser Vorgehensweise ist wegen der Aushärtezeit des Klebstoffs tendenziell langsam, sie kann aber beschleunigt werden, wenn ein Klebstoff verwendet wird, der durch Bestrahlen mit UV-Licht ausgehärtet wird. Als Distanzstück verwendet man dann ein lichtundurchlässiges, nicht materialanhaftendes Plättchen, beispielsweise ein Plättchen aus Teflon, dass Licht eines UV-Strahlers, der bezogen auf den Bezugsanschlag mit dem Distanzstück auf den Klebstoff aufgefahren und für die benötigte Aushärtezeit eingeschaltet wird, nur wenig geschwächt wird.

Ein zusätzlicher, separater zentraler Aspekt der Erfindung ist der Gedanke, das mechanische Übertragungselement eines optoelektronischen Sensors mit einem Bedienelement als ein Hebel auszulegen. Der Hebel ist beispielsweise an einem Ende gelagert und die Betätigung des Schaltelements erfolgt am gegenüberliegenden Ende des Hebels. Dazwischen wirkt das Tastelement auf den Hebel. Dadurch kann eine Vergrößerung des Hubes, bezogen vom Bedienhub zum Ausgangshub am Schaltelement des elektrischen Tastelement, erreicht werden.

In Weiterbildung der Erfindung ist es auch vorgesehen, eine Verkleinerung des Hubes vorzusehen. Dazu ist ein Hebel an einem Ende gelagert und die Betätigung des Tastelementes erfolgt am gegenüberliegenden Ende des Hebels. Dazwischen erfolgt die Betätigung des Schaltelements. Dadurch ist zum einen ein vergrößerter Hub des Tastelementes möglich und auch eine Vergrößerung der Kraft auf das Betätigungselement.

Besonders bevorzugt ist ein elastisch verformbarer Hebel, da dadurch eine zu hohe Kraftübertragung ausgeschlossen wird. Bei zu großem Bedienhub biegt sich der Hebel durch und unterbindet so eine Kraftübertragung zum elektrischen Tastelement und auf dessen Lagerung. Die Elastizität kann durch Materialwahl, geometrische Anordnung oder Beeinflussung des Flächenträgheitsmomentes durch Querschittsverjüngungen eingestellt werden, wobei sichergestellt sein muss, dass die minimal erforderliche Betätigungskraft und der minimal erforderliche Hub für das Schaltelement des elektrischen Tastelements erreicht werden. All diese Vorteile werden auch unabhängig von der Toleranzeliminierung durch Anpassung des mechanischen Übertragungselements erreicht.

In einer besonders bevorzugten Ausgestaltung des Verfahrens verwendet man nicht nur einen Hebel, sondern einen Hebel, der besonders gut geeignet für die erfindungsgemäße Anpassung der Länge in Arbeitsrichtung ist. Dies ist ein Hebel, bei der ein an den Hebel angeordneter Zapfen die bei Betätigung der Bedienfläche ausgeübte Kraft in den Hebel einleitet, da dann die Längenanpassung auf diesen Zapfen beschränkt bleiben kann.

Besonders vorteilhaft ist es bei dieser Ausgestaltung, wenn der Hebel nach dem Einlegen verliersicher an dem optoelektronischen Sensor fixiert wird. Dies kann z. B. mit Rast- und Klemmverbindungen realisiert werden. Insbesondere kann z. B. der Hebel auf der Seite, mit der das elektrische Tastelement bedient wird, einen Vorsprung aufweisen, der schräg von oben an einem im Gehäuse des optoelektronischen Sensors angeordneten Hinterschnitt vorbeigeführt wird. Anschließend wird der gegenüberliegende Bereich des Hebels in einen Schacht, der im Gehäuse oder in einer im Gehäuse angeordneten Halterung vorgesehen ist, eingeclipst.

Der erfindungsgemäße optoelektronische Sensor weist mindestens ein Bedienelement auf, das seinerseits eine Bedienfläche, ein elektrisches Tastelement und ein mechanisches, als Folge einer Betätigung der Bedienfläche bewegliches Übertragungselement zur Betätigung des elektrischen Tastelements aufweist. Erfindungswesentlich ist, dass das mechanische Übertragungselement, insbesondere seine Länge in Arbeitsrichtung, zur Toleranzeliminierung angepasst ist. Dadurch werden Bauteiltoleranzen ausgeglichen, so dass bei den auf diese Weise hergestellten optoelektronischen Sensoren mit Bedienelement die oben genannten Probleme nicht mehr auftreten können. Der Ausschuss an Geräten bei der Herstellung und das Risiko einer Beschädigung des Bedienelements bei seiner Betätigung werden sicher eliminiert, was zu spürbarer Kostenreduktion führt.

Besonders bevorzugt ist ein elastisch verformbarer Hebel, da dadurch eine zu hohe Kraftübertragung ausgeschlossen wird. Bei zu großem Bedienhub biegt sich der Hebel durch und unterbindet so eine Kraftübertragung zum elektrischen Tastelement und auf dessen Lagerung. Die Elastizität kann durch Materialwahl, geometrische Anordnung oder Beeinflussung des Flächenträgheitsmomentes durch Querschittsverjüngungen eingestellt werden. Besonders gut geeignet für die erfindungsgemäße Anpassung der Länge in Arbeitsrichtung ist ein Hebel, bei dem ein an dem Hebel angeordneter Zapfen die bei Betätigung der Bedienfläche ausgeübte Kraft in den Hebel einleitet, da dann die Längenanpassung auf diesen Zapfen beschränkt bleiben kann.

Eine verliersichere Variante des optoelektronischen Sensors hat die weiteren Merkmale, dass ein erstes Ende des Hebels an einem Hinterschnitt vorbeigeführt ist und dass ein zweites Ende des Hebels in einen Schacht eingeclipst ist.

Wenn an der Seite des Hebels, an der der Hebel aufliegend gelagert ist, ein flexibles Federelement angebracht ist, welches sich unter Vorspannung am Außengehäuse abstützt, erhält man einen optoelektronischen Sensor, bei dem Rasselgeräusche vermieden werden. Im engsten Toleranzfall wird dieses Federelement bei Betätigung des Hebels maximal durchgebogen. Die erforderliche Durchbiegekraft addiert sich zur eigentlichen Betätigungskraft des Hebels (ohne Federelement) hinzu.

Ein Ausführungsbeispiel der Erfindung wird anhand der folgenden Figuren ausführlich erläutert.

Es zeigt:
- Fig. 1: eine Querschnittsdarstellung eines Ausschnitts eines ersten Ausfüh-rungsbeispiels der Erfindung,
- Fig. 2: das Ausführungsbeispiel aus Figur 1 vor der Durchführung der Län-genanpassung des mechanischen Übertragungselements und
- Fig. 3: eine Querschnittsdarstellung eines Ausschnitts eines weiteren Ausfüh-rungsbeispiels der Erfindung mit einem Hebel als mechanischem Über-tragungselement.

Für gleiche Bauteile gleicher Ausführungsbeispiele werden dieselben Bezugszeichen verwendet.

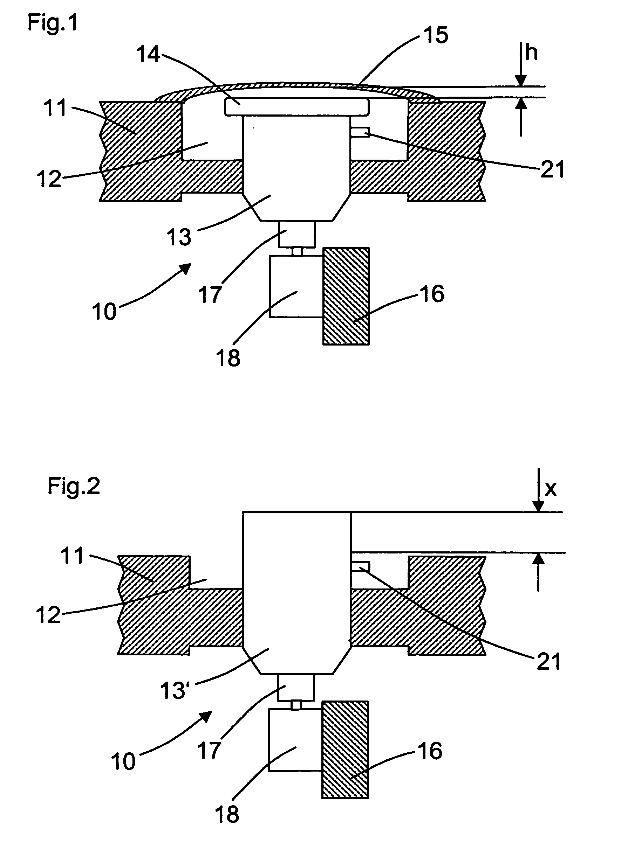

Fig. 1 zeigt eine Querschnittsdarstellung eines Ausschnitts eines ersten Ausführungsbeispiels der Erfindung. Dargestellt ist ein Ausschnitt eines optoelektronischen Sensors 10 mit einem Bedienelement, der die Umgebung des Bedienelements darstellt. Das Bedienelement weist eine Bedienfläche 15, hier dargestellt als Teachmembran, die an einem Abschnitt eines Gehäuses 11 des optoelektronischen Sensors 10 angeordnet ist, auf. Die Bedienfläche 15 hat einen in Figur 1 als h bezeichneten Arbeitshub. Vorzugsweise weist das Gehäuse 11 eine in Figur 1 nicht dargestellte Referenzfläche auf, die zur Referenzierung dieses Abstandes beim Anpassen des mechanischen Übertragungselements 13 verwendet werden kann.

Der Abschnitt des Gehäuses 11 wird von einer Ausnehmung 12 durchsetzt. Zumindest abschnittsweise innerhalb der Ausnehmung 12 ist ein mechanisches Übertragungselement 13 so angeordnet, dass es bei Betätigung der Bedienfläche 15 beweglich ist. Im Inneren des Gehäuses 11 ist eine Elektronikkarte 16 angeordnet. Auf der Elektronikkarte 16 ist ein elektrisches Tastelement 18 mit einem Schaltelement 17 so angeordnet, dass bei Betätigung der Bedienfläche 14 das mechanische Übertragungselement 13 eine Kraft auf das Schaltelement 17 ausübt, die zu einem Schalten des elektrischen Tastelements 18 führt.

Die Länge des mechanischen Übertragungselements 13 ist in Arbeitsrichtung zur Toleranzeliminierung angepasst, wie anhand eines an der Bedienfläche 15 zugewandten Seite des mechanischen Übertragungselements 13 angeordneten Wulstes 14 aus geschmolzenem Material erkennbar ist, so dass sichergestellt ist, dass mittels des Arbeitshubes h das Schalten des elektrischen Tastelements 18 ausgelöst werden kann. Das mechanische Übertragungselement 13 weist weiter an einer Seite einen Vorsprung 21 oder eine Stufe auf, die in die Ausnehmung 12 hineinragt. An dieser Stufe kann bei der Herstellung des optoelektronischen Sensors ein nicht dargestellter Niederhalter eingreifen, der das mechanische Übertragungselement 13 in eine Position überführt, in der es ein Schalten des elektrischen Tastelements 18 auslöst und das mechanische Übertragungselement 13 in dieser Position festhält, während die Anpassung des mechanischen Übertragungselements 13 erfolgt.

Je nachdem wie die Anpassung des mechanischen Übertragungselements erfolgt ist, kann ihre Durchführung auch statt aus dem Vorhandensein des Wulstes 14 aus dem Vorhandensein einer Fräsfläche, einer Oberfläche mit Kneifspuren oder eines Klebstofftropfens jeweils auf der der Bedienfläche 14 zugewandten Seite gefolgert werden.

Figur 2 zeigt das Ausführungsbeispiel aus Figur 1 vor der Durchführung der Längenanpassung des in Figur 1 mit dem Bezugszeichen 13 bezeichneten mechanischen Übertragungselements. Figur 2 unterscheidet sich somit von der Darstellung aus Figur 1 nur dahingehend, dass an die Stelle des mechanischen Übertragungselements 13 ein in der Länge noch nicht angepasstes mechanisches Übertragungselement 13' tritt, das um eine in der Figur 2 mit x gekennzeichnete Länge gegenüber seiner Solllänge übersteht. Die Solllänge ist dabei eine Länge, die zu einem Überstehen des mechanischen Übertragungselements 13,13' relativ zur der einer Außenseite des optoelektronischen Sensors 10 zuzurechnenden Oberfläche des Gehäuses 11 um den in Figur 1 dargestellten Abstand h führt. Das bedeutet, dass die vom Schaltelement 17 abgewandte Oberfläche des mechanischen Übertragungselements 13' in seiner Bewegungsrichtung um den Abstand x+h von einer Außenseite des optoelektronischen Sensors 10 zuzurechnenden Oberfläche des Gehäuses 11 entfernt ist.

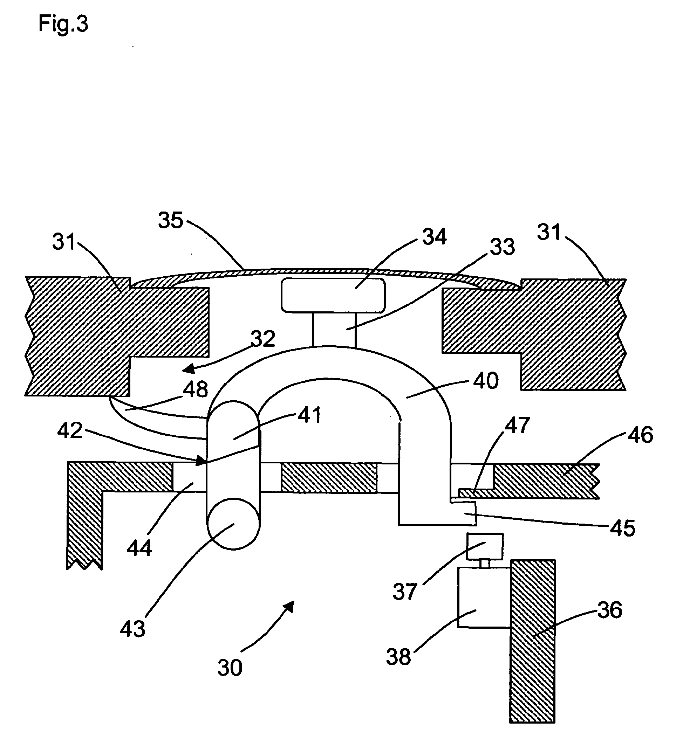

Fig. 3 zeigt eine Querschnittsdarstellung eines Ausschnitts eines weiteren Ausführungsbeispiels der Erfindung mit einem Hebel 40 als mechanisches Übertragungselement. Dargestellt ist ein Ausschnitt eines optoelektronischen Sensors 30 mit einem Bedienelement, der die Umgebung des Bedienelements darstellt. Das Bedienelement weist eine Bedienfläche 35, hier dargestellt als Teachmembran, die an einem Abschnitt eines Gehäuses 31 des optoelektronischen Sensors 30 angeordnet ist, auf. Vorzugsweise weist das Gehäuse 31 eine in Figur 3 nicht dargestellte Referenzfläche auf, die zur Referenzierung des Abstandes beim Anpassen des mechanischen Übertragungselements, d. h. in dieser Ausführungsform des Hebels 40, verwendet werden kann.

Der Abschnitt des Gehäuses 31 wird von einer Ausnehmung 32 durchsetzt. Zumindest abschnittsweise innerhalb der Ausnehmung 32 ist der Hebel 40 so angeordnet, dass er bei Betätigung der Bedienfläche 35 beweglich ist.

Im Inneren des Gehäuses 31 ist eine Elektronikkarte 36 angeordnet, die in einer nicht dargestellten Halterung fixiert ist. Auf der Elektronikkarte 36 ist ein elektrisches Tastelement 38 mit einem Schaltelement 37 so angeordnet, dass bei Betätigung der Bedienfläche 35 der Hebel 40 eine Kraft auf das Schaltelement 37 ausübt, die zu einem Schalten des elektrischen Tastelements 38 führt.

Der Hebel 40 ist einseitig verschiebbar aufliegend mit einer Stufe 41 an einem Auflagepunkt 42 gelagert und an der Seite, an der sich der Auflagepunkt des Hebels 40 befindet, zusätzlich mit einem Klemmkörper 43 in einen Hinterschnitt eines Schachts 44 eines im Gehäuse 31 des optoelektronischen Sensors 30 angeordneten Trägers 46 eingeclipst. Die andere Seite des Hebels 40, die das Schalten des elektrischen Tastelements 38 auslöst, weist eine Nase 45 auf, die einen Hinterschnitt 47 am Träger 46 hintergreift, so dass eine Verliersicherung gegen Herausschütteln gegeben ist.

Eine weitere Zusatzfunktion des Hebels 40, nämlich eine ein Rasseln vermeidende Fixierung des Hebels 40 in dem optoelektronischen Sensor 30 wird dadurch erzielt, dass an der Seite des Hebels, an der sie gelagert ist, ein flexibles Federelement 48 angeordnet ist, das sich, insbesondere im weitesten Toleranzfall, unter Vorspannung am Gehäuse 31 abstützt.

Zur Anpassung der Länge des Hebels 40 in Arbeitsrichtung zur Toleranzeliminierung ist in dieser Ausführungsform an dem Hebel 40 ein Zapfen 33 angeordnet, über den ein bei Betätigung auf die Bedienfläche 35 ausgeübter Druck in den Hebel 40 eingeleitet wird, so dass es zu einem einseitigen Kippen des Hebels 40 kommt, was wiederum die Betätigung des elektrischen Tastelements 38 über das Schaltelement 37 auslöst. Die Anpassung erfolgt vorzugsweise am Zapfen 33. Wenn sie durch Schmelzen des Materials erfolgt, ist die Durchführung der Anpassung anhand eines an der Bedienfläche 35 zugewandten Seite des Zapfens 33 angeordneten Wulstes 34 aus geschmolzenem Material erkennbar, so dass sichergestellt ist, dass mittels des verfügbaren, in Figur 3 nicht dargestellten Arbeitshubes das Schalten des elektrischen Tastelements 38 ausgelöst werden kann. Selbstverständlich sind auch alle anderen oben beschriebenen Vorgehensweisen zur Längenanpassung des Zapfens 33 möglich.

In der Ausführungsform nach Figur 3 kann bei der Herstellung des optoelektronischen Sensors ein nicht dargestellter Niederhalter neben dem Zapfen 33 an dem Hebel 40 angreifen, der den Hebel 40 in eine Position überführt, in der sie ein Schalten des elektrischen Tastelements 30 auslöst und den Hebel 40 in dieser Position festhält, während die Anpassung des Zapfens 33 erfolgt.

Das Übertragungselement oder der Hebel kann in Gerätegehäusen der unterschiedlichsten Geräte, beispielsweise von Mess- oder Regelgeräten, insbesondere von elektronischen oder optoelektronischen Sensoren, wie beispielsweise Lichtschranken oder Lichtgittern, verwendet werden. Die Gerätegehäuse finden Verwendung in Industriezweigen, in welchen hohe Anforderungen an Dichtigkeit, Temperaturbeständigkeit, Temperaturwechselbeständigkeit, mechanische Abriebfestigkeit, Durchdruckbeständigkeit gegen äußere mechanische Einwirkungen, Dampf- und Gasdurchlässigkeit, geringe Feuchtigkeitsaufnahme und/oder Hygieneanforderungen vorhanden sind, insbesondere im Bereich der Lebensmittelindustrie, der Nahrungs-, Genussmittel- und/oder Getränkeindustrie, der Solarenergieindustrie oder der Pharmaindustrie, in welchen insbesondere die verwendeten Geräte mit Chemikalien, insbesondere aggressiven Chemikalien gereinigt werden. Die Gerätegehäuse erfüllen die Anforderungen bis zu der Dichtigkeitsklasse IP69k.

### Bezugszeichenliste:

- 10,30: Optoelektronischer Sensor mit Bedienelement
- 11,31: Gehäuse
- 12,32: Ausnehmung
- 13: mechanisches Übertragungselement
- 14,34: Wulst
- 15,35: Bedienfläche
- 16,36: Elektronikkarte
- 17,37: Schaltelement
- 18,38: elektrisches Tastelement
- 21: Vorsprung
- 33: Zapfen
- 41: Stufe
- 42: Auflagepunkt
- 43: Klemmkörper
- 44: Schacht
- 45: Nase
- 46: Träger
- 47: Hinterschnitt
- 48: flexibles Federelement
- 49: Hebel

## Patentansprüche

1. Verfahren zur Herstellung eines Geräts mit einem Gehäuse (11, 31) mit einem Bedienelement, das eine Bedienfläche (15,35), ein elektrisches Tastelement (18,38) und ein mechanisches, als Folge einer Betätigung der Bedienfläche bewegliches Übertragungselement (13,40) zur Betätigung des elektrischen Tastelements (18,38) aufweist und die Bedienfläche an einem Abschnitt des Gehäuses (11, 31) angeordnet ist, das zumindest die Schritte aufweist:
- Anordnen des elektrischen Tastelements (18,38) in oder an dem Gerät,
- Einlegen des mechanischen Übertragungselements (13,40) in das Gerät, so dass durch Bewegung des mechanischen Übertragungselements (13,40) ein Schalten des elektrischen Tastelements (18,38) auslösbar ist,
- Überführen des mechanischen Übertragungselements (13,40) in eine Position, in der es ein Schalten des elektrischen Tastelements (18,38) auslöst und Festhalten des mechanischen Übertragungselements (13,40) in dieser Position, und
- Anpassen der Länge des mechanischen Übertragungselements (18,38) in Arbeitsrichtung zur Toleranzeliminierung, während das mechanische Übertragungselement (13, 40) in dieser Position festgehalten wird

2. Verfahren nach Anspruch 1,
**dadurch gekennzeichnet, dass** das Anpassen der Länge des mechanischen Übertragungselements (13,40) durch Abschmelzen erfolgt.

3. Verfahren nach Anspruch 1,
**dadurch gekennzeichnet, dass** das Anpassen der Länge des mechanischen Übertragungselements (13,40) durch Abfräsen erfolgt.

4. Verfahren nach Anspruch 1,
**dadurch gekennzeichnet, dass** das Anpassen der Länge des mechanischen Übertragungselements (13,40) durch Abkneifen erfolgt.

5. Verfahren nach Anspruch 1,
**dadurch gekennzeichnet, dass** das Anpassen der Länge des mechanischen Übertragungselements (13,40) durch Auftrag eines Klebstoffs erfolgt.

6. Verfahren nach Anspruch 5,
**dadurch gekennzeichnet, dass** der Klebstoff durch Bestrahlen mit UV-Licht ausgehärtet wird.

7. Verfahren nach einem vorstehenden Anspruch,
**dadurch gekennzeichnet, dass** das mechanische Übertragungselement (13,40) ein Hebel (40) ist.

8. Verfahren nach Anspruch 7,
**dadurch gekennzeichnet, dass** der Hebel (40) nach dem Einlegen verliersicher an oder in dem Gerät fixiert wird.

## Claims

1. A method of manufacturing a device comprising a housing (11, 31) having an operating element which has an operating area (15, 35), an electrical sensing element (18, 38) and a mechanical transfer element (13, 40) which is movable as a consequence of an actuation of the operating area for activating the electrical sensing element (18, 38), and the operating area is arranged at a section of the housing (11, 31), which method comprises the steps:
- arranging the electrical sensing element (18, 38) in or at the device;
- inserting the mechanical transmission element (13, 40) into the device so that a switching of the electrical sensing element (18, 38) can be triggered by a movement of the mechanical transmission element (13, 40);
- moving the mechanical transmission element (13, 40) into a position in which it triggers a switching of the electrical sensing element (18, 38) and holding the mechanical transmission element (13, 40) in this position; and
- adapting the length of the mechanical transmission element (18, 38) in the working direction for tolerance minimisation while the mechanical transmission element (13, 40) is held in this position.

2. A method in accordance with claim 1,
**characterised in that** the adaptation of the length of the mechanical transmission element (13, 40) takes place by melting off.

3. A method in accordance with claim 1,
**characterised in that** the adaptation of the length of the mechanical transmission element (13, 40) takes place by milling off.

4. A method in accordance with claim 1,
**characterised in that** the adaptation of the length of the mechanical transmission element (13, 40) takes place by pinching off.

5. A method in accordance with claim 1,
**characterised in that** the adaptation of the length of the mechanical transmission element (13, 40) takes place by application of an adhesive.

6. A method in accordance with claim 5,
**characterised in that** the adhesive is hardened by irradiation with UV light.

7. A method in accordance with a preceding claim,
**characterised in that** the mechanical transmission element (13, 40) is a lever (40).

8. A method in accordance with claim 7,
**characterised in that** the lever (40) is fixed to or in the device in a manner secure against loss after the insertion.

## Revendications

1. Procédé pour la fabrication d'un appareil comprenant un boîtier (11, 31) avec un élément de manipulation, qui comporte une surface de manipulation (15, 35), un élément palpeur électrique (18, 38), et un élément de transmission mécanique (13, 41) déplaçable à la suite d'un actionnement de la surface de manipulation, pour l'actionnement de l'élément palpeur électrique (18, 38), et la surface de manipulation est agencée sur une portion du boîtier (11, 31), qui comprend au moins les étapes consistant à :
- agencer l'élément palpeur électrique (18, 38) dans ou sur l'appareil,
- mettre l'élément de transmission mécanique (13, 40) en place dans l'appareil, de sorte que par déplacement de l'élément de transmission mécanique (13, 40) il est possible de déclencher une commutation de l'élément palpeur électrique (18, 38),
- transférer l'élément de transmission mécanique (13, 40) jusque dans une position dans laquelle il déclenche une commutation de l'élément palpeur électrique (18, 38), et maintenir l'élément de transmission mécanique (13, 40) dans cette position, et
- adapter la longueur de l'élément de transmission mécanique (18, 38) en direction de travail pour éliminer les tolérances, pendant que l'on maintient l'élément de transmission mécanique (13, 40) dans cette position.

2. Procédé selon la revendication 1,
**caractérisé en ce que** l'adaptation de la longueur de l'élément de transmission mécanique (13, 40) a lieu par fusion.

3. Procédé selon la revendication 1,
**caractérisé en ce que** l'adaptation de la longueur de l'élément de transmission mécanique (13, 40) a lieu par fraisage.

4. Procédé selon la revendication 1,
**caractérisé en ce que** l'adaptation de la longueur de l'élément de transmission mécanique (13, 40) a lieu par découpe.

5. Procédé selon la revendication 1,
**caractérisé en ce que** l'adaptation de la longueur de l'élément de transmission mécanique (13, 40) a lieu par application d'une colle.

6. Procédé selon la revendication 5,
**caractérisé en ce que** la colle est durcie par irradiation avec de la lumière ultraviolette.

7. Procédé selon une revendication précédente,
**caractérisé en ce que** l'élément de transmission mécanique (13, 40) est un levier (40).

8. Procédé selon la revendication 7,
**caractérisé en ce que**, après sa mise en place, le levier (40) est fixé de manière imperdable sur ou dans l'appareil.
